# EUROPÄISCHE PATENTSCHRIFT

(11) **EP 3 350 847 B1**
(45) Veröffentlichungstag und Bekanntmachung des Hinweises auf die Patenterteilung: **06.11.2019**
(21) Anmeldenummer: 16766949.8
(22) Anmeldetag: 16.09.2016
(51) Int. Cl.: H01L 33/58, B29C 67/00, B29C 64/135, B33Y 80/00

(54) **VERFAHREN ZUM AUSBILDEN EINES ODER MEHRERER DREIDIMENSIONALER OBJEKTE UND OPTOELEKTRONISCHE LEUCHTVORRICHTING**
METHOD FOR FORMING ONE OR MORE THREE-DIMENSIONAL OBJECTS AND OPTOELECTRONIC LIGHTING DEVICE
PROCÉDÉ DE FORMATION D'UN OU DE PLUSIEURS OBJETS TRIDIMENSIONNELS ET DISPOSITIF D'ÉCLAIRAGE OPTOÉLECTRONIQUE

(30) Priorität: 18.09.2015 DE 102015115796
(43) Veröffentlichungstag der Anmeldung: 25.07.2018
(73) Patentinhaber: OSRAM Opto Semiconductors GmbH, 93055 Regensburg (DE)
(72) Erfinder: GMEINWIESER, Nikolaus, 93093 Donaustauf (DE)
(74) Vertreter: Patentanwaltskanzlei WILHELM & BECK
(86) Internationale Anmeldenummer: PCT/EP2016/071949
(87) Internationale Veröffentlichungsnummer: WO 2017/046316

(56) Entgegenhaltungen:
- WO-A1-2012/163946
- WO-A1-2015/092014
- DE-A1-102012 212 320
- DE-A1-102015 105 509
- JP-A- 2012 162 025
- US-A1- 2015 102 532
- US-A1- 2015 221 835
- US-B2- 9 099 575

## Beschreibung

Die Erfindung betrifft ein Verfahren zum Ausbilden eines oder mehrerer dreidimensionaler Objekte. Die Erfindung betrifft ferner eine optoelektronische Leuchtvorrichtung.

Diese Patentanmeldung beansprucht die Priorität der deutschen Patentanmeldung 10 2015 115 796.9, deren Offenbarungsgehalt hiermit durch Rückbezug aufgenommen wird.

Aus der Druckschrift John R. Tumbleston et al., Science, VOL 347, ISSUE 6228, Seiten 1349 bis 1352, 20. März 2015 mit dem Titel "Continuous liquid interface production of 3D objects" ist ein dreidimensionales fotolithographisches Druckverfahren bekannt, bei dem mittels eines UV-härtenden Kunststoffes durch UV-Belichtung ein dreidimensionales Objekt ausgebildet wird.

Aus der Offenlegungsschrift WO 2014/126837 A2 ist ein Verfahren zum Ausbilden eines dreidimensionalen Objekts bekannt, wobei analog zum vorstehend beschriebenen Science-Artikel ein UV-aushärtender Kunststoff mittels UV-Licht belichtet wird, um ein dreidimensionales Objekt auszubilden.

Die der Erfindung zugrunde liegende Aufgabe ist darin zu sehen, ein effizientes Konzept zum Ausbilden eines oder mehrerer dreidimensionaler Objekte für eine einen Träger mit einem optoelektronischen Halbleiterbauteil umfassende optoelektronische Leuchtvorrichtung bereitzustellen.

Diese Aufgabe wird mittels des jeweiligen Gegenstands der unabhängigen Ansprüche gelöst. Vorteilhafte Ausgestaltungen der Erfindung sind Gegenstand von jeweils abhängigen Unteransprüchen.

Nach einem Aspekt wird ein Verfahren zum Ausbilden eines oder mehrerer dreidimensionaler Objekte für eine einen Träger mit einem optoelektronischen Halbleiterbauteil umfassende optoelektronische Leuchtvorrichtung bereitgestellt, umfassend die folgenden Schritte:
- Bereitstellen eines Trägers einer optoelektronischen Leuchtvorrichtung, wobei auf dem Träger ein optoelektronisches Halbleiterbauteil angeordnet ist, wobei ein vom Träger teilweise begrenzter Aufbaubereich festgelegt ist, dem das optoelektronische Halbleiterbauteil zugewandt ist,
- Einbringen einer polymerisierbaren Flüssigkeit in den Aufbaubereich,
- Belichten des Aufbaubereichs, um ein oder mehrere Festkörperpolymere aus der polymerisierbaren Flüssigkeit in einer vom Aufbaubereich umfassten Aushärtezone auszubilden, um ein oder mehrere dreidimensionale Objekte aus dem oder den mehreren Festkörperpolymeren in der Aushärtezone auszubilden,
- wobei während des Belichtens des Aufbaubereichs ein unwirksamer Bereich gebildet wird, in welchem eine Polymerisation inhibiert wird, wobei die Aushärtezone zwischen dem Träger und dem unwirksamen Bereich angeordnet ist.

Gemäß einem weiteren Aspekt wird eine optoelektronische Leuchtvorrichtung bereitgestellt, umfassend:
- einen Träger, auf welchem ein optoelektronisches Halbleiterbauteil angeordnet ist, und
- ein oder mehrere dreidimensionale Objekte, die jeweils mittels des Verfahrens zum Ausbilden eines oder mehrerer dreidimensionaler Objekte ausgebildet sind.

Die Erfindung umfasst also insbesondere und unter anderem den Gedanken, ein oder mehrere dreidimensionale Objekte für eine optoelektronische Leuchtvorrichtung mittels eines so genannten 3D-Druckverfahrens auszubilden. Dadurch wird insbesondere der technische Vorteil bewirkt, dass das oder die mehreren dreidimensionalen Objekte für die optoelektronische Leuchtvorrichtung effizient hergestellt werden können. In der Regel ist mittels eines 3D-Druckverfahrens eine Vielzahl an möglichen Formen und Geometrien für das oder die mehreren dreidimensionalen Objekte möglich. Somit lassen sich in effizienter Weise optoelektronische Leuchtvorrichtungen herstellen, die komplett unterschiedlich und individuell angefertigte dreidimensionale Objekte aufweisen. Insbesondere sind mittels des 3D-Druckverfahrens in vorteilhafter Weise Formen von Objekten möglich, die in einem Spritzgussprozess oder nur durch Zusammensetzen von mehreren Einzelteilen in der Regel nicht möglich sind.

Des Weiteren bietet das 3D-Druckverfahren insbesondere in vorteilhafter Weise eine hohe Flexibilität, die eine effiziente Herstellung auch von Kleinserien oder von Produkten mit vielen Varianten erlaubt. Denn so muss nicht in einem Spritzgussprozess für jedes zu fertigende Bauteil eine eigene Spritzgussform hergestellt werden. Dies ist in der Regel aufwändig, so dass dies sich in der Regel nur bei Großserien lohnt.

Aufgrund der Besonderheit des dreidimensionalen Druckverfahrens wird der oder werden die mehreren Festkörperpolymere am Träger respektive am Halbleiterbauteil direkt ausgebildet. Somit sind also die dreidimensionalen Objekte nach einem Aushärten der polymerisierbaren Flüssigkeit bereits mit dem Träger respektive dem Halbleiterbauteil effizient verbunden, so dass auf die sonst üblichen Klebeschritte verzichtet werden kann.

Dadurch, dass während des Belichtens ein unwirksamer Bereich gebildet, wird insbesondere der technische Vorteil bewirkt, dass durch den mittels des unwirksamen Bereichs geschaffenen Raum polymerisierbare Flüssigkeit nachfließen kann, ohne dass es in dem unwirksamen Bereich zu einer Aushärtung der polymerisierbaren Flüssigkeit kommt. Dadurch ist in vorteilhafter Weise eine besonders schnelle Ausbildung des oder der dreidimensionalen Objekte ermöglicht.

Ein Inhibieren umfasst insbesondere ein Verlangsamen, ein Hemmen oder ein Verhindern der Polymerisation. Das heißt also, dass in dem unwirksamen Bereich die polymerisierbare Flüssigkeit nur verlangsamt polymerisiert respektive dass eine Polymerisation gehemmt oder verhindert ist oder wird.

Der unwirksame Bereich kann insofern insbesondere als eine inhibierte Zone bezeichnet werden.

Die Aushärtezone bezeichnet eine Zone innerhalb des Aufbaubereichs, in welcher die Flüssigkeit aufgrund des Belichtens polymerisiert, also aushärtet.

Nach einer Ausführungsform sind ferner folgende Schritte vorgesehen:
- Bereitstellen eines optisch transparenten Elements mit einer Aufbaufläche, wobei das optoelektronische Halbleiterbauteil der Aufbaufläche zugewandt ist, wobei der Aufbaubereich mittels des Trägers und der Aufbaufläche als der zwischen dem Träger und der Aufbaufläche liegende Bereich festgelegt wird,
- Auffüllen des Aufbaubereichs mit der polymerisierbaren Flüssigkeit,
- Belichten des Aufbaubereichs durch das optisch transparente Element bei gleichzeitiger Vorwärtsbewegung des Trägers weg von der Aufbaufläche, um in der Aushärtezone ein oder mehrere Festkörperpolymere aus der polymerisierbaren Flüssigkeit auszubilden, um ein oder mehrere dreidimensionale Objekte in der Aushärtezone aus dem oder den mehreren Festkörperpolymeren auszubilden, bei gleichzeitiger Ausführung des folgenden Schritts:
   - fortlaufendes Aufrechterhalten eines Kontakts zwischen dem unwirksamen Bereich der polymerisierbaren Flüssigkeit und der Aufbaufläche.

Das Einbringen einer polymerisierbaren Flüssigkeit in den Aufbaubereich umfasst somit nach einer Ausführungsform ein

Auffüllen des Aufbaubereichs mit der polymerisierbaren Flüssigkeit.

Dadurch, dass während des Belichtens und während der gleichzeitigen Vorwärtsbewegung des Trägers weg von der Aufbaufläche ein Kontakt zwischen dem unwirksamen Bereich der polymerisierbaren Flüssigkeit, in welchem eine Polymerisation inhibiert wird, und der Aufbaufläche fortlaufend aufrecht erhalten wird, wird insbesondere der technische Vorteil bewirkt, dass beim Vorwärtsbewegen des Trägers weg von der Aufbaufläche polymerisierbare Flüssigkeit in den aufgrund der Vorwärtsbewegung geschaffenen Raum nachfließen kann, ohne dass es in dem unwirksamen Bereich zu einer Aushärtung der polymerisierbaren Flüssigkeit kommt. Das heißt also, dass unmittelbar an der Aufbaufläche eine Aushärtung inhibiert wird, so dass die polymerisierbare Flüssigkeit nachfließen kann, wenn sich der Träger weg von der Aufbaufläche bewegt. Dadurch ist in vorteilhafter Weise eine besonders schnelle Ausbildung des oder der dreidimensionalen Objekte ermöglicht.

Sofern ein solch unwirksamer Bereich nicht vorgesehen wäre, so würde die Flüssigkeit unmittelbar an der Aufbaufläche aufgrund der Belichtung aushärten, so dass dann kein Nachfließen mehr von Flüssigkeit möglich ist, wenn der Träger vorwärts bewegt wird.

Nach einer Ausführungsform ist vorgesehen, dass das oder die mehreren dreidimensionalen Objekte jeweils ein Element ausgewählt aus der folgende Gruppe von dreidimensionalen Objekten sind: Gehäusewand für ein Gehäuse für das Halbleiterbauteil, Lichtleiter zum Leiten von mittels des Halbleiterbauteils emittierten Lichts weg vom Halbleiterbauteil, Linse zum optischen Abbilden von mittels des Halbleiterbauteils emittierten Lichts.

Das Vorsehen einer Gehäusewand für ein Gehäuse für das Halbleiterbauteil weist insbesondere den technischen Vorteil auf, dass das Halbleiterbauteil gegenüber äußeren Einflüssen effizient geschützt werden kann. Dadurch, dass die Gehäusewand mittels des erfindungsgemäßen Verfahrens ausgebildet wird respektive ist, wird insbesondere der technische Vorteil bewirkt, dass die Gehäusewand effizient und schnell und in unterschiedlichen Variationen hergestellt werden kann.

Das Vorsehen eines Lichtleiters weist insbesondere den technischen Vorteil auf, dass das Licht, welches mittels des Halbleiterbauteils in seinem Betrieb emittiert wird, effizient vom Halbleiterbauteil weggeleitet werden kann. Dadurch, dass der Lichtleiter mittels des erfindungsgemäßen Verfahrens hergestellt ist respektive wird, wird insbesondere der technische Vorteil bewirkt, dass beliebige Formen für den Lichtleiter möglich sind.

Das Vorsehen der Linse weist insbesondere den technischen Vorteil auf, dass das Licht, welches mittels des Halbleiterbauteils in seinem Betrieb emittiert wird, effizient abgebildet werden kann. Dadurch, dass die Linse mittels des erfindungsgemäßen Verfahrens ausgebildet ist respektive wird, wird insbesondere der technische Vorteil bewirkt, dass beliebige Linsenformen möglich sind. So kann zum Beispiel in vorteilhafter Weise eine bestimmte Abbildcharakteristik der Linse eingestellt werden. Zum Beispiel kann so ein Brennpunkt der Linse effizient eingestellt werden.

Nach einer Ausführungsform ist vorgesehen, dass bei einer Gehäusewand diese derart ausgebildet wird, dass die Gehäusewand eine dem Träger abgewandte Halbleiterbauteilfläche des Halbleiterbauteils überragt, um die Halbleiterbauteilfläche zumindest teilweise gegen elektromagnetische Strahlung abzuschirmen.

Dadurch wird insbesondere der technische Vorteil bewirkt, dass das Halbleiterbauteil effizient zumindest teilweise gegen elektromagnetische Strahlung abgeschirmt werden kann. Dies ist zum Beispiel dann von Vorteil, wenn das Halbleiterbauteil als eine Fotodiode ausgebildet ist, so dass dann aufgrund der Abschirmung die Fotodiode in vorteilhafter Weise effizient gegen Streulicht abgeschirmt werden kann. Sofern sich auf dem Träger noch zusätzlich eine Leuchtdiode befindet, die in ihrem Betrieb Licht emittiert, könnte dieses Licht zu einer Verfälschung einer Messung der Fotodiode führen. Die Abschirmung durch die entsprechend ausgebildete Gehäusewand bewirkt aber in vorteilhafter Weise, dass das Licht der Leuchtdiode die Fotodiode nicht erreicht.

In einer Ausführungsform weist die Gehäusewand ein Unterschnitt auf.

In einer Ausführungsform wird eine Gehäusewand mit einem Unterschnitt gebildet.

Das Vorsehen eines Unterschnitts weist insbesondere den technischen Vorteil auf, dass dadurch eine effiziente Abschirmung des Halbleiterbauteils gegenüber Streulicht bewirkt werden kann.

In einer weiteren Ausführungsform ist ein dreidimensionales Objekt ein Hohlkörper mit einer Öffnung, wobei das Halbleiterbauteil im Hohlkörper aufgenommen ist.

Dadurch wird insbesondere der technische Vorteil bewirkt, dass das Halbleiterbauteil effizient gegen äußere Einflüsse geschützt werden kann. Insbesondere wird dadurch eine effiziente Abschirmung gegenüber Streulicht bewirkt.

In einer weiteren Ausführungsform ist vorgesehen, dass das optoelektronische Halbleiterbauteil als eine Fotodiode ausgebildet ist.

In einer weiteren Ausführungsform ist vorgesehen, dass das optoelektronische Halbleiterbauteil als eine Leuchtdiode ausgebildet ist.

In einer weiteren Ausführungsform ist vorgesehen, dass das optoelektronische Halbleiterbauteil als eine Laserdiode ausgebildet ist.

In einer Ausführungsform ist das Halbleiterbauteil als ein Halbleiterchip, insbesondere als ein Leuchtdiodenchip oder als ein Laserdiodenchip, ausgebildet.

In einer weiteren Ausführungsform sind mehrere optoelektronische Halbleiterbauteile auf dem Träger angeordnet. Diese sind identisch oder unterschiedlich ausgebildet.

In einer weiteren Ausführungsform ist vorgesehen, dass bei einem Lichtleiter dieser auf einer lichtemittierenden Fläche des Halbleiterbauteils ausgebildet wird.

Dadurch wird insbesondere der technische Vorteil bewirkt, dass der Lichtleiter unmittelbar auf der lichtemittierenden Fläche angeordnet ist, so dass dieser besonders effizient das emittierte Licht weg vom Halbleiterbauteil leiten kann. Insbesondere muss ein derartig ausgebildeter Lichtleiter nicht noch zusätzlich mit der lichtemittierenden Fläche verklebt werden. Dadurch wird ferner insbesondere eine effiziente Herstellung bewirkt.

Nach einer Ausführungsform ist vorgesehen, dass bei einer Linse diese auf einer lichtemittierenden Fläche des Halbleiterbauteils ausgebildet wird.

Dadurch wird insbesondere der technische Vorteil bewirkt, dass das emittierte Licht effizient mittels der Linse abgebildet werden kann. Insbesondere muss eine derart ausgebildete Linse nicht mehr aufwändig mit der lichtemittierenden Fläche verklebt werden.

Bei mehrere auf dem Träger angeordneten Halbleiterbauteilen ist nach einer Ausführungsform vorgesehen, dass auf den Halbleiterbauteile jeweils eine eigene Linse oder ein eigener Lichtleiter angeordnet ist. Insbesondere ist die jeweilige Abbildcharakteristik der Linsen derart, dass diese das mittels des jeweiligen Halbleiterbauteils emittierte Licht in einen gemeinsamen Brennpunkt abbilden.

In einer weiteren Ausführungsform ist vorgesehen, dass eine Verankerungsstruktur zum Verankern des oder der mehreren Festkörperpolymere am Träger vorgesehen ist.

Dadurch wird insbesondere der technische Vorteil bewirkt, dass der oder die mehreren Festkörperpolymere effizient am Träger verankert werden können. Dadurch wird also in vorteilhafter Weise eine effiziente Befestigung des oder der mehreren Festkörperpolymere am Träger ermöglicht. Dadurch kann also eine entsprechend ausgebildete optoelektronische Leuchtvorrichtung auch in rauen Umgebungsbedingungen verwendet werden. Solch raue Umgebungsbedingungen umfassen zum Beispiel Erschütterungen.

In einer weiteren Ausführungsform ist vorgesehen, dass die Verankerungsstruktur zumindest teilweise integral mit dem Träger ausgebildet ist und/oder wobei die Verankerungsstruktur zumindest teilweise als ein körperlich vom Träger separates und auf diesem angeordnetes Bauteil ausgebildet ist.

Dadurch, dass die Verankerungsstruktur zum Beispiel zumindest teilweise integral mit dem Träger ausgebildet ist, wird insbesondere der technische Vorteil bewirkt, dass der Träger effizient als eine Verankerung für den oder die mehreren Festkörperpolymere fungiert. Das heißt also, dass der Träger zusätzlich zu seiner die Halbleiterbauteile oder das Halbleiterbauteil tragenden Funktion noch eine weitere Funktion aufweist: eine Verankerungsfunktion.

Dadurch, dass die Verankerungsstruktur zum Beispiel zumindest teilweise als ein körperlich vom Träger separates und auf diesem angeordnetes Bauteil ausgebildet ist, wird insbesondere der technische Vorteil bewirkt, dass die Verankerungsstruktur unabhängig vom Träger ausgebildet werden kann. Das heißt, dass insbesondere beim Ausbilden des Bauteils der Verankerungsstruktur weniger Rücksicht auf Besonderheiten des Trägers genommen werden muss als wenn die Verankerungsstruktur integral mit dem Träger ausgebildet ist. Denn so kann es zum Beispiel Fälle geben, in welchen aufgrund besonderer Anforderungen oder Spezifikationen der Träger keine Verankerungsstruktur aufweisen darf. Dennoch ist auch in diesem Fall eine Verankerung des einen oder der mehreren Festkörperpolymer effizient ermöglicht, indem ein separates Bauteil hierfür vorgesehen ist, das diese Verankerungsfunktion übernimmt.

Die Verankerungsstruktur weist nach einer Ausführungsform eine dreidimensionale Struktur auf, die auch als ein Relief bezeichnet werden kann. Zum Beispiel weist eine Oberfläche des Trägers eine dreidimensionale Struktur auf. Das heißt, dass die Oberfläche nicht plan oder eben ist, sondern zum Beispiel Erhebungen und Vertiefungen aufweist. Das heißt, dass allgemein nach einer Ausführungsform vorgesehen ist, dass die dreidimensionale Struktur Erhebungen und/oder Vertiefungen und/oder Löcher aufweist. Dies gilt analog für das separate Bauteil. Auch dieses weist nach einer Ausführungsform eine solch dreidimensionale Struktur auf, die vorzugsweise Erhebungen und/oder Vertiefungen und/oder Löcher umfasst.

In einer weiteren Ausführungsform ist vorgesehen, dass eine Haftvermittlerschicht zum Anhaften des oder der mehreren Festkörperpolymere am Träger vorgesehen ist.

Dadurch wird insbesondere der technische Vorteil bewirkt, dass ein effizientes Anhaften des oder der mehreren Festkörperpolymere am Träger ermöglicht ist. Das heißt, dass die Haftvermittlerschicht eine effiziente Befestigung des einen oder der mehreren Festkörperpolymere am Träger ermöglicht. Dadurch wird also in vorteilhafter Weise eine optoelektronische Leuchtvorrichtung geschaffen, welche auch in rauen Umgebungsbedingungen, die zum Beispiel Erschütterungen umfassen, eingesetzt werden kann. Die Haftvermittlerschicht ist zum Beispiel von der Verankerungsstruktur umfasst.

In einer weiteren Ausführungsform ist vorgesehen, dass nach dem Einbringen der polymerisierbaren Flüssigkeit in den Aufbaubereich und vor und/oder während des Belichtens mittels des Halbleiterbauteils ultraviolettes Licht emittiert wird, um die polymerisierbare Flüssigkeit zu polymerisieren.

Dadurch wird insbesondere der technische Vorteil bewirkt, dass in einem Bereich um das Halbleiterbauteil die Flüssigkeit effizient polymerisiert werden kann. Das heißt also, dass dadurch unmittelbar um das Halbleiterbauteil ein Bereich geschaffen ist, in welchem die Flüssigkeit aufgrund der UV-Belichtung aushärtet. Dies weist insbesondere den technischen Vorteil auf, dass über diesen ausgehärteten Bereich eine effiziente Befestigung oder Anhaftung oder Verankerung des Festkörperpolymers am Träger respektive am Halbleiterbauteil ermöglicht ist.

In einer weiteren Ausführungsform ist vorgesehen, dass der Träger eine Beschichtung aufweist, die ausgebildet ist, eine Wellenlänge des Belichtungslichts zu mindestens 50 % zu absorbieren.

Dadurch wird insbesondere der technische Vorteil bewirkt, dass aufgrund von Reflektionen des Belichtungslichts am Träger eine Verfälschung der dreidimensionalen Form des dreidimensionalen Objekts vermieden werden kann.

Das Belichtungslicht bezeichnet hier das Licht, welches auf den Aufbaubereich durch das optische transparente Element beaufschlagt wird.

Nach einer Ausführungsform wird mittels UV-Licht belichtet. Das heißt, dass das Belichtungslicht UV-Licht ist. UV-Licht bezeichnet elektromagnetische Strahlung in einem Wellenlängenbereich von 1 nm bis 400 nm.

Nach einer Ausführungsform umfasst der Träger eine Keramik respektive ist ein Keramikträger.

In einer weiteren Ausführungsform ist der Träger eine Leiterplatte. Eine Leiterplatte wird im Englischen als "Printed Circuit Board (PCB)" bezeichnet. Die Leiterplatte kann auch als eine Leiterkarte, Platine oder als eine gedruckte Schaltung bezeichnet werden. Eine Leiterplatte umfasst insbesondere ein elektrisch isolierendes Material mit daran haftenden, leitenden Verbindungen (Leiterbahnen).

Nach einer Ausführungsform ist der Träger als eine Metallkernplatine ausgebildet.

Nach einer Ausführungsform ist auf dem Halbleiterbauteil ein Konverter zum Konvertieren von Licht angeordnet, welches mittels des Halbleiterbauteils in seinem Betrieb emittiert wird. Der Konverter ist also ausgebildet, mittels des Halbleiterbauteils in seinem Betrieb emittiertes Licht zu konvertieren.

Konvertieren heißt insbesondere, dass das emittierte Licht mit einer ersten Wellenlänge respektive mit einem ersten Wellenlängenbereich in konvertiertes Licht mit einer zweiten Wellenlänge respektive mit einem zweiten Wellenlängenbereich konvertiert wird. Die erste Wellenlänge ist verschieden von der zweiten Wellenlänge. Der erste Wellenlängenbereich und der zweite Wellenlängenbereich sind zumindest teilweise unterschiedlich.

Der Konverter ist zum Beispiel als ein Konverterplättchen ausgebildet.

Der Konverter ist zum Beispiel als eine Konverterschicht ausgebildet, die mittels eines Beschichtungsverfahrens auf das Halbleiterbauteil aufgebracht ist. Ein solches Beschichtungsverfahren umfasst zum Beispiel eine Elektrophorese und/oder ein so genanntes "Spray Coating".

Der Konverter umfasst zum Beispiel ein oder mehrere Phosphore.

Nach einer Ausführungsform ist das Halbleiterbauteil mittels einer Vergussmasse vergossen. Das heißt, dass das Halbleiterbauteil in einer Vergussmasse zumindest teilweise, insbesondere vollständig, eingebettet ist. In einer solchen Ausführungsform ist dann also zum Beispiel vorgesehen, dass der oder die Festkörperpolymere auf der Vergussmasse ausgebildet werden.

Nach einer Ausführungsform umfasst respektive ist die polymerisierbare Flüssigkeit ein Silikon.

Nach einer Ausführungsform umfasst respektive ist die polymerisierbare Flüssigkeit ein oder mehrere Ormocere.

In einer weiteren Ausführungsform umfasst respektive ist die polymerisierbare Flüssigkeit ein Epoxid.

Nach einer Ausführungsform ist vorgesehen, dass das optisch transparente Element ein semipermeables Element umfasst.

Durch das semipermeables Element kann in vorteilhafter Weise ein Polymerisationsinhibitor zur Aufbaufläche gelangen.

In einer Ausführungsform ist vorgesehen, dass das fortlaufende Aufrechterhalten eines unwirksamen Bereichs dadurch ausgeführt wird, dass ein Polymerisationsinhibitor durch das optisch transparente Element geführt wird, wobei in dem unwirksamen Bereich ein Inhibitorgefälle erzeugt wird. Das heißt, dass eine Polymerisationsinhibitorkonzentration mit zunehmender Entfernung zur Aufbaufläche abnimmt. Dies bewirkt, dass mit zunehmender Entfernung zur Aufbaufläche ein Polymerisationsgrad zunimmt. Dadurch wird als ein Polymerisationsgradient ausgebildet. Ein Polymerisationsbereich weist somit einen Gradienten auf.

In einer weiteren Ausführungsform ist vorgesehen, dass das optisch transparente Element als semipermeables Element ein semipermeables Fluorpolymer, ein starres, für Gas permeables Polymer, poröses Glas oder eine Kombination aus diesen aufweist.

Dadurch wird insbesondere der technische Vorteil bewirkt, dass ein Polymerisationsinhibitor zum Aufrechterhalten des unwirksamen Bereiches effizient durch das optisch transparente Element geleitet werden kann.

Nach einer Ausführungsform ist der Polymerisationsinhibitor Sauerstoff respektive umfasst der Polymerisationsinhibitor Sauerstoff.

In einer weiteren Ausführungsform ist vorgesehen, dass der Belichtungsschritt durch ein maskenloses Fotolithographie-Verfahren erfolgt.

In einer weiteren Ausführungsform ist vorgesehen, dass der Belichtungsschritt mit einer zweidimensionalen Belichtungsstruktur ausgeführt wird, welche auf oder in die Aufbaufläche projiziert wird, wobei sich die Struktur mit der Zeit verändert, wobei der gleichzeitige Schritt der Vorwärtsbewegung ausreichend lange fortgesetzt wird, um das oder die dreidimensionalen Objekte auszubilden.

Zum Beispiel wird die zweidimensionale Belichtungsstruktur mittels einer Bildprojektionseinrichtung projiziert. Eine solche Bildprojektionseinrichtung kann auch als ein Videoprojektor bezeichnet werden.

Nach einer Ausführungsform ist vorgesehen, dass während der Vorwärtsbewegung und während des Belichtens zusätzlich folgender Schritt ausgeführt wird: fortlaufendes Aufrechterhalten eines Gradienten eines Polymerisationsbereichs zwischen dem unwirksamen Bereich und dem oder den mehreren Festkörperpolymeren, wobei im Kontakt mit diesen Komponenten der Gradient des Polymerisationsbereichs die polymerisierbare Flüssigkeit in teilweise ausgehärteter Form umfasst.

In einer Ausführungsform ist vorgesehen, dass eine Schutzdiode auf dem Träger angeordnet ist. Die Schutzdiode ist zum Beispiel innerhalb eines dreidimensionalen Objekts, insbesondere einer Gehäusewand, vorzugsweise einer Gehäuseseitenwand, eingeschlossen. Das heißt, dass ein Träger umfassend das Halbleiterbauteil und die Schutzdiode bereitgestellt wird, wobei das Bilden des Objekts derart ausgeführt wird, dass das Objekt die Schutzdiode einschließt oder umschließt. Dadurch wird in vorteilhafter Weise bewirkt, dass die Schutzdiode weniger bis kein Licht mehr adsorbieren kann, wodurch die Schutzdiode, die üblicherweise Silizium umfasst, effizient betrieben werden kann. Die Schutzdiode bewirkt zum Beispiel einen Schutz vor elektrostatischen Entladungen und/oder bewirkt zum Beispiel einen Schutz für Überspannungen, die das Halbleiterbauteil beschädigen können.

Nach einer Ausführungsform ist das Halbleiterbauteil als Flip-Chip ausgebildet. Das heißt, dass eine elektrische Kontaktierung des Halbleiterbauteils von einer Unterseite des Halbleiterbauteils bewirkt ist.

In einer Ausführungsform ist das Halbleiterbauteil mittels eines Bonddrahts elektrisch kontaktiert.

In einer weiteren Ausführungsform weist das Halbleiterbauteil für seine elektrische Kontaktierung an seiner Oberseite eine planare elektrische Kontaktfläche auf. Die Kontaktfläche umfasst zum Beispiel eine fotolithographische Struktur. Das heißt zum Beispiel, dass die Kontaktfläche als eine fotolithographische Kontaktfläche ausgebildet ist.

Der Lichtleiter ist nach einer Ausführungsform zum Beispiel derart ausgebildet, dass eine Lichtleitung und/oder eine Lichtauskopplung einen optischen Eindruck eines Glühfadens oder einer Glühwendel bewirken.

Der Lichtleiter umfasst nach einer Ausbildungsform einen Hohlzylinder.

Der Lichtleiter umfasst nach einer Ausführungsform mehrere Lichtleiterverzweigungen auf. Der Lichtleiter verzweigt sich also.

Nach einer Ausführungsform ist ein erstes Längsende des Hohlzylinders auf dem Halbleiterbauteil angeordnet und an dem ersten Längsende gegenüberliegenden Längsende des Hohlzylinders sind mehrere Lichtleiterverzweigungen gebildet.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei
Fig. 1 eine erste optoelektronische Leuchtvorrichtung,
Fig. 2 eine zweite optoelektronische Leuchtvorrichtung,
Fig. 3 eine dritte optoelektronische Leuchtvorrichtung,
Fig. 4 eine vierte optoelektronische Leuchtvorrichtung,
Fig. 5 eine fünfte optoelektronische Leuchtvorrichtung,
Fig. 6 eine sechste optoelektronische Leuchtvorrichtung,
Fig. 7 eine siebente optoelektronische Leuchtvorrichtung,
Fig. 8 eine achte optoelektronische Leuchtvorrichtung während eines Ausbildens eines dreidimensionalen Objekts,
Fig. 9 ein Ablaufdiagramm eines Verfahrens zum Ausbilden eines oder mehrerer dreidimensionaler Objekte und
Fig. 10 ein Ablaufdiagramm eines weiteren Verfahrens zum Ausbilden eines oder mehrerer dreidimensionaler Objekte
zeigen.

Im Folgenden können für gleiche Merkmale gleiche Bezugszeichen verwendet werden.

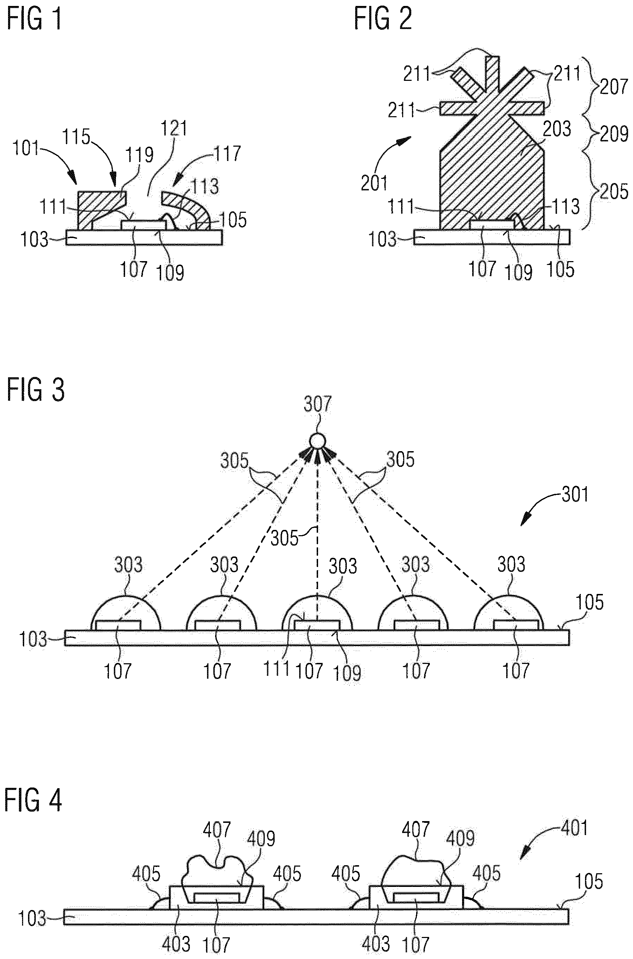

Fig. 1 zeigt eine erste optoelektronische Leuchtvorrichtung 101 in einer seitlichen Schnittansicht.

Die optoelektronische Leuchtvorrichtung 101 umfasst einen Träger 103. Auf einer Oberseite 105 des Trägers 103 ist ein optoelektronisches Halbleiterbauteil 107 angeordnet. Das optoelektronische Halbleiterbauteil 107 ist zum Beispiel ein Halbleiterchip. Das optoelektronische Halbleiterbauteil 107 weist eine Unterseite 109 und eine der Unterseite 109 gegenüberliegende Oberseite 111 auf. Das Halbleiterbauteil 107 ist mit seiner Unterseite 109 auf der Oberseite 105 des Trägers 103 angeordnet. Das heißt, dass die Oberseite 111 des Halbleiterbauteils 107 der Oberseite 105 des Trägers 103 abgewandt ist.

Die Oberseite 111 des Halbleiterbauteils 107 ist mit einem Bonddraht 113 mit der Oberseite 105 des Trägers 103 elektrisch verbunden.

Bezogen auf die Papierebene sind links und rechts vom Halbleiterbauteil 107 zwei Gehäuseseitenwände 115, 117 auf der Oberseite 105 des Trägers 103 ausgebildet. Hierbei sind diese beiden Gehäuseseitenwände 115, 117 gemäß dem erfindungsgemäßen Verfahren zum Ausbilden eines oder mehrerer dreidimensionaler Objekte ausgebildet worden. Die beiden Gehäuseseitenwände 115, 117 bilden somit Gehäusewände eines Gehäuses für das Halbleiterbauteil 107.

Es ist zum Beispiel vorgesehen, dass die beiden Gehäuseseitenwände 115, 117 umlaufend um das Halbleiterbauteil 107 ausgebildet sind. Es ist zum Beispiel vorgesehen, dass noch weitere hier nicht gezeigte Gehäuseseitenwände vorgesehen sind, die mit den Gehäuseseitenwänden 115, 117 ein Gehäuse für das Halbleiterbauteil 107 bilden.

Die Gehäuseseitenwand 117 weist eine Viertel-Bogenform auf und überdeckt somit zumindest einen Teil der Oberseite 105 des Trägers 103.

Die Gehäuseseitenwand 115 weist einen Abschnitt 119 auf, der die Oberseite 111 des Halbleiterbauteils 107 zumindest teilweise überragt.

Das heißt, dass beide Gehäuseseitenwände 115, 117 einen Unterschnitt aufweisen.

Das heißt, dass beide Gehäuseseitenwände 115, 117 derart ausgebildet sind, dass sie jeweils einen Abschnitt aufweisen, der als eine Abschirmung, analog zu einem Dach, wirkt, so dass elektromagnetische Strahlung zum Halbleiterbauteil 107 respektive elektromagnetische Strahlung vom dem Halbleiterbauteil 107 weg nur durch eine Lücke 121 zwischen den beiden die Abschirmung bewirkenden Abschnitte der beiden Gehäuseseitenwände 115, 117 strahlen kann.

In einer nicht gezeigten Ausführungsform ist vorgesehen, dass das Halbleiterbauteil 107 zumindest teilweise, insbesondere vollständig, vergossen wird respektive ist. Das heißt also, dass zum Beispiel eine Vergussmasse oder ein Vergussmaterial in die Kavität, die durch die beiden Gehäuseseitenwände 115, 117 gebildet wird, eingebracht wird.

Die Form der beiden Gehäuseseitenwände 115, 117 kann aufgrund der speziellen Ausbildung gemäß dem erfindungsgemäßen Verfahren in einer Vielzahl von Formen hergestellt werden, so dass je nach konkretem Anwendungsfall unterschiedliche Formen hergestellt werden können. Hierfür ist es nicht notwendig, jedes Mal eine spezielle Form und Gussform herzustellen. Vielmehr reicht es aus, mittels einer der gewünschten Form entsprechenden Belichtung den Aufbaubereich zu belichten und gleichzeitig den Träger 103 weg von der Aufbaufläche wegzubewegen, bei gleichzeitiger Aufrechterhaltung eines Kontakts zwischen dem unwirksamen Bereich und der Aufbaufläche.

An sich bekannte Verfahren zum Herstellen eines Gehäuses für ein Halbleiterbauteil umfassen in einem ersten Schritt, dass die Gehäusewände separat hergestellt werden. Diese Gehäusewände werden dann in einem zweiten Schritt in aufwendigen Klebeverfahren auf den Träger geklebt, so dass die geklebten Gehäusewände ein Gehäuse für das Halbleiterbauteil bilden. In einem dritten Schritt wird dann das Halbleiterbauteil vergossen. Das heißt, dass das gehäuste Halbleiterbauteil zum Beispiel vergossen wird.

Das erfindungsgemäße Konzept sieht hingegen vor, dass zunächst in einem ersten Schritt der Träger mit dem Halbleiterbauteil bereitgestellt wird, so dass in einem zweiten Schritt Gehäusewände direkt am Träger mittels des erfindungsgemäßen Verfahrens ausgebildet werden können, so dass aufwendige Klebeschritte entfallen. Ferner besteht eine hohe Flexibilität hinsichtlich der Formen und Geometrien der Gehäusewände.

In einer nicht gezeigten Ausführungsform ist vorgesehen, dass eine Schutzdiode auf dem Träger angeordnet ist. Die Schutzdiode ist zum Beispiel innerhalb einer der Gehäuseseitenwände 115, 117 eingeschlossen. Das heißt, dass ein Träger umfassend das Halbleiterbauteil und die Schutzdiode bereitgestellt werden, wobei das Bilden der Gehäuseseitenwände derart ausgeführt wird, dass eine der Gehäuseseitenwände die Schutzdiode einschließt oder umschließt. Dadurch wird in vorteilhafter Weise bewirkt, dass die Schutzdiode weniger bis kein Licht mehr adsorbieren kann, wodurch die Schutzdiode, die üblicherweise Silizium umfasst, effizient betrieben werden kann.

Fig. 2 zeigt eine zweite optoelektronische Leuchtvorrichtung 201 in einer seitlichen Schnittansicht.

Die optoelektronische Leuchtvorrichtung 201 umfasst analog zur ersten optoelektronischen Leuchtvorrichtung 101 der Fig. 1 einen Träger 103 und ein optoelektronisches Halbleiterbauteil 107. Auf die diesbezüglichen Ausführungen wird zur Vermeidung von Wiederholungen verwiesen.

Auf der Oberseite 105 ist ein Lichtleiter 203 ausgebildet, wobei der Lichtleiter 203 auch die Oberseite 111 des Halbleiterbauteils 107 bedeckt. Das heißt, dass der Lichtleiter 203 auf der Oberseite 111 des Halbleiterbauteils 107 ausgebildet oder angeordnet ist.

Auch der Lichtleiter 203 ist mittels des erfindungsgemäßen Verfahrens zum Ausbilden eines oder mehrerer dreidimensionaler Objekte ausgebildet worden. Der Lichtleiter 203 umfasst einen geradlinigen Abschnitt 205, der sich weg von der Oberseite 111 des Halbleiterbauteils 107 erstreckt. Dieser geradlinige Abschnitt 205 weist eine Zylinder- oder Rohrform auf. Dem geradlinigen Abschnitt 205 schließt sich ein konisch zulaufender oder sich verjüngender Abschnitt 209 an, an welchem sich ein Freiformabschnitt 207 anschließt. Der Freiformabschnitt 207 weist fünf Lichtleiterverzweigungen 211 auf, die sternförmig vom sich verjüngenden Abschnitt 209 abgehen.

Der Lichtleiter 203 weist somit eine Form auf, die übliche Lichtleiter in der Regel nicht aufweisen, da diese Form mit bekannten Herstellungsverfahren in der Regel nicht oder nur mit großem Aufwand herzustellen ist. Aufgrund des erfindungsgemäßen Konzepts, dass der Lichtleiter 203 mittels Belichten einer polymerisierbaren Flüssigkeit erzeugt wird, kann eine solche Freiform effizient hergestellt werden.

Da ferner noch das fortlaufende Aufrechterhalten des Kontakts zwischen dem unwirksamen Bereich der polymerisierbaren Flüssigkeit und der Aufbaufläche vorgesehen ist, kann der Lichtleiter 203 (dies gilt ebenfalls für die beiden Gehäuseseitenwände 115, 117 der optoelektronischen Leuchtvorrichtung 101 der Fig. 1) besonders schnell hergestellt werden im Vergleich zu bisher bekannten 3D-Druckverfahren. Denn durch das Aufrechterhalten des Kontakts wird in vorteilhafter Weise bewirkt, dass polymerisierbare Flüssigkeit bei der Vorwärtsbewegung nachfließen kann.

Fig. 3 zeigt eine dritte optoelektronische Leuchtvorrichtung 301 in einer seitlichen Schnittansicht.

Die Leuchtvorrichtung 301 umfasst einen Träger 103 und mehrere Halbleiterbauteile 107. Die Halbleiterbauteile 107 sind nebeneinander auf der Oberseite 105 des Trägers 103 angeordnet. Obwohl in Fig. 3 nicht explizit gezeigt, ist zum Beispiel vorgesehen, dass die mehreren Halbleiterbauteile 107 analog zu den in Fig. 1 und 2 gezeigten Leuchtvorrichtungen 101, 201 mit einem Bonddraht 113 mit der Oberseite 105 des Trägers 103 elektrisch verbunden sind. Zum Beispiel ist vorgesehen, dass die Halbleiterbauteile 107 derart ausgebildet sind, dass sie von ihrer Unterseite 109 kontaktiert werden. Ein solch ausgebildetes Halbleiterbauteil kann als ein Flip-Chip bezeichnet werden. In einer zum Flip-Chip alternativen Ausführungsform weisen die Halbleiterbauteile 107 zum Beispiel an ihrer Oberseite 111 jeweils eine planare elektrische Kontaktfläche auf. Die Kontaktfläche ist zum Beispiel als eine fotolithographische Kontaktfläche ausgebildet.

Auf jeder der Halbleiterbauteile 107 ist jeweils eine Linse 303 ausgebildet oder angeordnet, die Licht, welches mittels der Halbleiterbauteile 107 im Betrieb emittiert wird, abbilden kann. Auch die Linsen 303 sind gemäß dem erfindungsgemäßen Verfahren zum Ausbilden eines oder mehrerer dreidimensionaler Objekte ausgebildet worden.

Hierbei sind die mehreren Linsen 303 derart ausgebildet, dass sie das jeweilige emittierte Licht auf einen gemeinsamen Brennpunkt 307 abbilden. Dies ist symbolisch mittels Lichtstrahlen 305 gezeigt, die jeweils von den Halbleiterbauteilen 107 abgehen und auf den gemeinsamen Brennpunkt 307 zeigen.

Das heißt also, dass es mittels des erfindungsgemäßen Verfahrens effizient ermöglicht ist, jede der Linsen 303 mit einer individuellen Abbildcharakteristik zu versehen, damit diese das Licht in einen gemeinsamen Brennpunkt 307 abbilden.

Fig. 4 zeigt eine vierte optoelektronische Leuchtvorrichtung 401 in einer seitlichen Schnittansicht.

Die optoelektronische Leuchtvorrichtung 401 umfasst einen Träger 103, der hier als eine Leiterplatte ausgebildet ist. Auf der Oberseite 105 des Trägers 103 sind zwei Halbleiterbauteile 107 angeordnet. Hierbei sind die beiden Halbleiterbauteile 107 in einem Gehäuse 403 angeordnet, welches mittels eines Vergussprozesses gebildet wurde. Das heißt, dass sich die beiden Halbleiterbauteile 107 jeweils in einem Vergussgehäuse befinden. Die Halbleiterbauteile 107 sind über Bonddrähte 405 mit der Oberseite 105 des Trägers 103 elektrisch kontaktiert oder verbunden.

Auf einer Oberseite 409 des jeweiligen Gehäuses 403 ist mittels des erfindungsgemäßen Verfahrens zum Ausbilden eines oder mehrerer dreidimensionaler Objekte eine Freiformlinse 407 angeordnet. Die Form oder Geometrie der Freiformlinsen 407 kann in vorteilhafter Weise variantenreich und flexibel ausgebildet werden. Somit erhalten die beiden Halbleiterbauteile 107 jeweils individuelle Abbildungsoptiken. Dadurch lassen sich zum Beispiel in vorteilhafter Weise besondere optische Eindrücke erzielen.

Die beiden Linsen 407 werden nach einer Ausführungsform vor der elektrischen Kontaktierung der beiden Halbleiterbauteile 107 mit der Oberseite 105 des Trägers 103 auf den Oberseiten 409 ausgebildet. In einer anderen Ausführungsform wird zuerst die elektrische Kontaktierung durchgeführt und dann das Ausbilden der beiden Freiformlinsen 407.

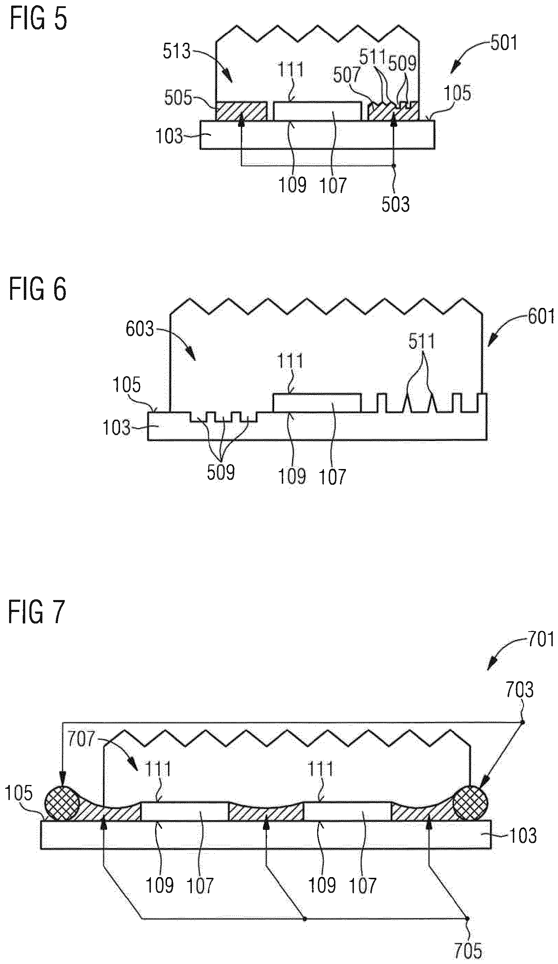

Fig. 5 zeigt eine fünfte optoelektronische Leuchtvorrichtung 501 in einer seitlichen Schnittansicht.

Die optoelektronische Leuchtvorrichtung 501 umfasst einen Träger 103, wobei auf der Oberseite 105 des Trägers 103 ein optoelektronisches Halbleiterbauteil 107 angeordnet ist. Ferner ist auf der Oberseite 105 des Trägers 103 eine Verankerungsstruktur 503 angeordnet. Die Verankerungsstruktur 503 umfasst ein Bauteil mit zwei Bauteilabschnitten 505, 507. Das Bauteil mit den zwei Bauteilabschnitten 505, 507 ist auf der Oberseite 105 des Trägers 103 angeordnet und umläuft oder umschließt das Halbleiterbauteil 107 und ist derart ausgebildet, dass mittels der Bauteilabschnitte 505, 507 eine Verankerungsstruktur gebildet ist.

Zum Beispiel umfasst der Bauteilabschnitt 507 Vertiefungen 509 und Erhebungen in Form von Spitzen 511. Das heißt, dass der Bauteilabschnitt 507 eine Oberflächenstruktur oder ein Oberflächenrelief aufweist. Das heißt, dass die Oberseite des Bauteilabschnitts 507 nicht plan ist.

Der Bauteilabschnitt 505 umfasst eine hier nicht im Detail dargestellte Haftvermittlerschicht, an welcher der Festkörperpolymer beim Aushärten gut und effizient anhaften kann. Auch dadurch ist eine Verankerung des Festkörperpolymers bewirkt.

Aufgrund der Oberflächenstruktur oder der Reliefstruktur des Bauteilabschnitts 507 ist ebenfalls eine effiziente Verankerung des Festkörperpolymers bewirkt.

Dieser Festkörperpolymer ist in Fig. 5 mit dem Bezugszeichen 513 versehen und bildet also ein dreidimensionales Objekt aus, welches auf dem Träger 103 ausgebildet oder angeordnet ist und an der Verankerungsstruktur 503 verankert ist.

Die beiden Bauteilabschnitte 505, 507 sind zum Beispiel derart ausgebildet, dass sie eine Höhe aufweisen, die einer Höhe des Halbleiterbauteils 107 bezogen auf die Oberseite 105 entspricht. Dadurch wird also ein Höhenausgleich bewirkt. Die beiden Bauteilabschnitte 505, 507 bilden ferner einen Rahmen für das Halbleiterbauteil 107.

Fig. 6 zeigt eine sechste optoelektronische Leuchtvorrichtung 601 in einer seitlichen Schnittansicht.

Die Leuchtvorrichtung 601 umfasst einen Träger 103, auf welchem ein Halbleiterbauteil 107 angeordnet ist. Die Oberseite 105 des Trägers 103 ist mit einem Relief oder einer dreidimensionalen Oberflächenstruktur versehen, die zum Beispiel Vertiefungen 509 und Erhebungen in Form von Spitzen 511 umfasst. Diese dreidimensionale Oberflächenstruktur bildet eine Verankerungsstruktur, an welcher ein dreidimensionales Objekt 603, welches gemäß dem erfindungsgemäßen Verfahren zum Ausbilden eines oder mehrerer dreidimensionaler Objekte hergestellt ist, verankert ist.

Die Verankerungsstruktur der Leuchtvorrichtung 601 der Fig. 6 ist integral mit dem Träger 103 ausgebildet.

Fig. 7 zeigt eine siebente optoelektronische Leuchtvorrichtung 701 in einer seitlichen Schnittansicht.

Die Leuchtvorrichtung 701 umfasst einen Träger 103, auf welchem zwei Halbleiterbauteile 107 angeordnet sind. Die beiden Halbleiterbauteile 107 umlaufend ist ein Damm 703 auf der Oberseite 105 des Trägers 103 ausgebildet oder angeordnet. Der Damm 703 ist zum Beispiel aus Silikon ausgebildet.

Der Damm 703 verhindert, dass ein Vergussmaterial 705, welches auf die Oberseite 105 des Trägers 103 zwischen den beiden Dämmen 703 und zwischen den Halbleiterbauteilen 107 aufgetragen oder aufgebracht wird, von dem Träger 103 herunterläuft.

Die optoelektronische Leuchtvorrichtung 701 umfasst ferner ein dreidimensional ausgebildetes Objekt 707, welches mittels des Verfahrens zum Ausbilden eines oder mehrerer dreidimensionaler Objekte ausgebildet oder hergestellt wurde. Das Objekt 707 ist sowohl auf den beiden Oberseiten 111 der Halbleiterbauteile 107 angeordnet als auch auf dem Vergussmaterial 705 selbst. Zum Beispiel ist vorgesehen, dass das Vergussmaterial 705 mit einer Haftvermittlungsschicht versehen oder beschichtet wird, so dass eine effiziente Anhaftung des Objekts 707 am Vergussmaterial 705 bewirkt werden kann.

Das Vergussmaterial 705 umfasst zum Beispiel Titandioxid (TiO2).

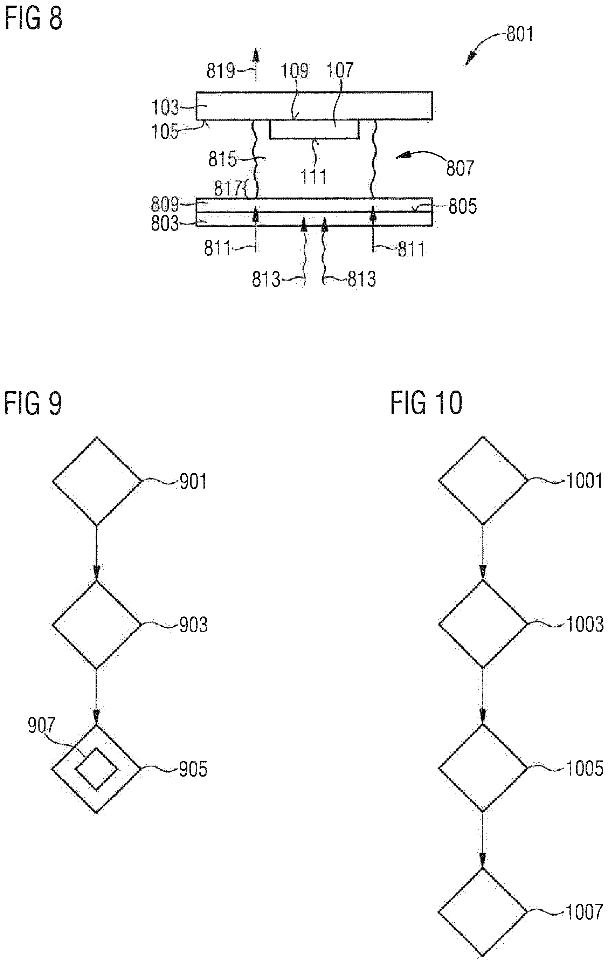

Fig. 8 zeigt eine achte optoelektronische Leuchtvorrichtung 801 in einer seitlichen Schnittansicht während eines Ausbildens eines dreidimensionalen Objekts 815 gemäß den erfindungsgemäßen Verfahren.

Die Leuchtvorrichtung 801 umfasst einen Träger 103, wobei an der Oberseite 105 des Trägers 103 das Halbleiterbauteil 107 angeordnet ist.

Ferner ist ein optisch transparentes Element 803 bereitgestellt, welches für ein Belichtungslicht optisch durchlässig ist. Das Element 803 weist eine Aufbaufläche 805 auf. Der Träger 103 ist mit seiner Oberseite 105 dieser Aufbaufläche 805 zugewandt. Das heißt, dass auch das Halbleiterbauteil 107 mit seiner Oberseite 111 dieser Aufbaufläche 805 des Elements 803 zugewandt ist.

Zwischen der Oberseite 105 und der Aufbaufläche 805 wird ein Aufbaubereich 807 festgelegt, der sich also zwischen dem Träger 103 und der Aufbaufläche 805 befindet.

In den Aufbaubereich 807 wird eine polymerisierbare Flüssigkeit eingebracht. Das heißt, dass dieser Aufbaubereich 807 mit einer polymerisierbaren Flüssigkeit aufgefüllt wird.

Um ein oder mehrere Festkörperpolymere aus der polymerisierbaren Flüssigkeit auszubilden, um ein oder mehrere dreidimensionale Objekte aus dem oder den mehreren Festkörperpolymeren auszubilden, ist vorgesehen, dass der Aufbaubereich 807 durch das optisch transparente Element 803 belichtet wird, zum Beispiel mittels UV-Licht. Das Belichten ist symbolisch mittels zwei gewellt gezeichneten Pfeilen mit dem Bezugszeichen 813 gekennzeichnet.

Im konkreten Ausführungsbeispiel der Fig. 8 wird ein dreidimensionales Objekt 815 ausgebildet, so dass mittels des Belichtens des Aufbaubereichs 807 ein Festkörperpolymer ausgebildet wird, aus welchem dann das Objekt 815 ausgebildet wird.

Während des Belichtens wird der Träger 103 weg von der Aufbaufläche 805 bewegt. Dies ist symbolisch mittels eines Pfeils 819 gekennzeichnet, der symbolisch diese Vorwärtsbewegung darstellen soll.

Damit aufgrund dieser Vorwärtsbewegung 819 des Trägers 103 stets polymerisierbare Flüssigkeit nachfließen kann, ist vorgesehen, dass während des Belichtens und während der Vorwärtsbewegung 819 ein unwirksamer Bereich 809 unmittelbar auf der Aufbaufläche 805 ausgebildet wird. Hierbei ist während des Belichtens und während der Vorwärtsbewegung 819 vorgesehen, dass dieser unwirksame Bereich 809 stets in Kontakt mit der Aufbaufläche 805 bleibt. Das heißt, dass ein Kontakt zwischen dem unwirksamen Bereich 809 der polymerisierbaren Flüssigkeit und der Aufbaufläche 805 fortlaufend aufrecht erhalten wird.

Der unwirksame Bereich 809 wird zum Beispiel dadurch gebildet, dass ein Polymerisationsinhibitor, zum Beispiel Sauerstoff, durch das optisch transparente Element 803 in den Aufbaubereich 807 diffundiert. Das heißt, dass zum Beispiel das Element 803 für einen solchen Polymerisationsinhibitor permeabel ausgebildet ist. Zum Beispiel ist das Element 803 für Sauerstoff durchlässig. Das Durchleiten oder Durchdiffundieren von Sauerstoff, allgemein eines Polymerisationsinhibitors, ist symbolisch mittels zwei Pfeilen mit den Bezugszeichen 811 gekennzeichnet.

Durch das Vorsehen des Inhibitors bildet sich somit der unwirksamer Bereich 809 aus, in welchem eine Polymerisation inhibiert wird. Nach diesem unwirksamen Bereich 809 ist ein Bereich gebildet, in welchem die Polymerisation einen Gradienten aufweist. Das heißt, dass in diesem Bereich ein Polymerisationsgrad der Flüssigkeit zunimmt, je weiter sich die Flüssigkeit von dem unwirksamen Bereich 809 befindet. Dieser Bereich, in welchem ein solcher Polymerisationsgradient vorliegt, ist symbolisch mit einer geschweiften Klammer mit dem Bezugszeichen 817 gekennzeichnet.

In dem Bereich 817 findet dann also das Aushärten oder Polymerisieren der Flüssigkeit statt, so dass sich letztlich das dreidimensionale Objekt 815 ausbildet. Der Bereich 817 bildet somit eine Aushärtezone
Aufgrund des fortlaufenden Aufrechterhaltens des Kontakts zwischen dem unwirksamen Bereich 809 der polymerisierbaren Flüssigkeit, in welchem eine Polymerisation inhibiert wird, und der Aufbaufläche 805, wird also in vorteilhafter Weise ein Nachfließen der polymerisierbaren Flüssigkeit erzielt oder bewirkt. Dadurch kann in vorteilhafter Weise das Objekt 815 fortlaufend, also während der Vorwärtsbewegung 819, ausgebildet werden. Dies im Vergleich zu bekannten 3D-Druckverfahren, die solch einen unwirksamen Bereich nicht vorsehen, so dass eine fortlaufende Vorwärtsbewegung nicht möglich ist, was eine Druckgeschwindigkeit reduziert.

Fig. 9 zeigt ein Ablaufdiagramm eines Verfahrens zum Ausbilden eines oder mehrerer dreidimensionaler Objekte für eine einen Träger mit einem optoelektronischen Halbleiterbauteil umfassende optoelektronische Leuchtvorrichtung.

Das Verfahren umfasst die folgenden Schritte:
- Bereitstellen 901 eines optisch transparenten Elements mit einer Aufbaufläche und eines Trägers einer optoelektronischen Leuchtvorrichtung, wobei auf dem Träger ein der Aufbaufläche zugewandtes optoelektronisches Halbleiterbauteil angeordnet ist, wobei der Träger und die Aufbaufläche einen dazwischen liegenden Aufbaubereich festlegen,
- Auffüllen 903 des Aufbaubereichs mit einer polymerisierbaren Flüssigkeit,
- Belichten 905 des Aufbaubereichs durch das optisch transparente Element bei gleichzeitiger Vorwärtsbewegung des Trägers weg von der Aufbaufläche, um ein oder mehrere Festkörperpolymere aus der polymerisierbaren Flüssigkeit auszubilden, um ein oder mehrere dreidimensionale Objekte aus dem oder den mehreren Festkörperpolymeren auszubilden, bei gleichzeitiger Ausführung des folgenden Schritts:
   - fortlaufendes Aufrechterhalten 907 eines Kontakts zwischen einem unwirksamen Bereich der polymerisierbaren Flüssigkeit, in welchem eine Polymerisation inhibiert wird, und der Aufbaufläche.

Fig. 10 zeigt ein Ablaufdiagramm eines weiteren Verfahrens zum Ausbilden eines oder mehrerer dreidimensionaler Objekte für eine einen Träger mit einem optoelektronischen Halbleiterbauteil umfassende optoelektronische Leuchtvorrichtung.

Das Verfahren umfasst die folgenden Schritte:
- Bereitstellen 1001 eines Trägers einer optoelektronischen Leuchtvorrichtung, wobei auf dem Träger ein optoelektronisches Halbleiterbauteil angeordnet ist, wobei ein vom Träger teilweise begrenzter Aufbaubereich festgelegt ist, dem das optoelektronische Halbleiterbauteil zugewandt ist,
- Einbringen 1003 einer polymerisierbaren Flüssigkeit in den Aufbaubereich,
- Belichten 1005 des Aufbaubereichs, um ein oder mehrere Festkörperpolymere aus der polymerisierbaren Flüssigkeit in einer vom Aufbaubereich umfassten Aushärtezone auszubilden, um ein oder mehrere dreidimensionale Objekte aus dem oder den mehreren Festkörperpolymeren in der Aushärtezone auszubilden,
- wobei während des Belichtens 1005 des Aufbaubereichs ein unwirksamer Bereich gebildet 1007 wird, in welchem eine Polymerisation inhibiert wird, wobei die Aushärtezone zwischen dem Träger und dem unwirksamen Bereich angeordnet ist.

Nach einer Ausführungsform wird ein Lichtleiter als ein dreidimensionales Objekt ausgebildet, insbesondere ein Lichtleiter für ein Kraftfahrzeugrücklicht.

Nach einer Ausführungsform wird ein Lichtleiter als ein dreidimensionales Objekt ausgebildet, insbesondere ein Lichtleiter zur Lichtverteilung in einem LED-Retrofit. Ein LED-Retrofit bezeichnet insbesondere eine Lampe, die in Form und Funktion einer konventionellen Lampe, zum Beispiel einer Glühbirne, nachgebildet ist.

Nach einer Ausführungsform wird ein Lichtleiter als dreidimensionales ausgebildet, insbesondere ein Lichtleiter zur Lichtverteilung in einem LED-Retrofit, wobei das Licht derart geleitet und aus dem Lichtleiter ausgekoppelt wird, dass sich für einen Betrachter im Betrieb ein optischer Eindruck wie der eines Glühfadens oder einer Glühwendel einer konventionellen Glühbirne ergibt.

Der Lichtleiter ist also nach einer Ausführungsform zum Beispiel derart ausgebildet, dass eine Lichtleitung und/oder eine Lichtauskopplung einen optischen Eindruck eines Glühfadens oder einer Glühwendel bewirken.

Der Lichtleiter umfasst nach einer Ausbildungsform einen Hohlzylinder.

Der Lichtleiter umfasst nach einer Ausführungsform mehrere Lichtleiterverzweigungen auf. Der Lichtleiter verzweigt sich also.

Nach einer Ausführungsform ist ein erstes Längsende des Hohlzylinders auf dem Halbleiterbauteil angeordnet und an dem ersten Längsende gegenüberliegenden Längsende des Hohlzylinders sind mehrere Lichtleiterverzweigungen gebildet.

Der erfindungsgemäße Grundgedanke ist insbesondere darin zu sehen, zum Beispiel Leuchtdiodenchips oder Leuchtdiodenpackages, auf einen Träger, der auch als eine Trägerplatte bezeichnet werden kann, aufzubringen. Die Platte ist beispielsweise eine Keramikplatte, eine Metallkernplatine oder eine Leiterplatte ("Printed Circuit Board"). Die Leiterplatte ist zum Beispiel starr oder zum Beispiel flexibel. Diese Platte mit dem aufgebrachten LED ("Light emitting diode", Leuchtdiode)-Chip oder mit den aufgebrachten LED-Chips oder mit dem aufgebrachten LED-Package wird dann in die polymerisierbare Flüssigkeit eingetaucht und das erfindungsgemäße Verfahren, wie vorstehend beschrieben, wird durchgeführt.

Vor dem Eintauchen ist nach einer Ausführungsform vorgesehen, dass ein Konverter in Form eines Plättchens oder mittels Elektrophorese oder mittels Spraycoatings auf die LED-Chips oder das LED-Package aufgebracht wird.

Nach einer Ausführungsform ist vorgesehen, ein planvergossenes Bauteil anstatt des Trägers zu verwenden, und auf diesem planvergossenen Bauteil eine Freiformlinse und/oder Lichtleiter aufzuwachsen oder aufzudrucken.

Durch das erfindungsgemäße 3D-Druckverfahren sind in vorteilhafter Weise Formen von Packages und Lichtleitern möglich, die im Spritzguss oder anderen konventionellen Verfahren nicht oder nur durch Zusammensetzen mehrerer Teile möglich wären. Die Flexibilität des 3D-Druckverfahrens erlaubt in vorteilhafter Weise auch eine effiziente Herstellung von Kleinserien oder Produkten mit vielen Varianten. Speziell bei dem Ausbilden eines Lichtleiters lassen sich die Leuchtdioden direkt in den Lichtleiter integrieren.

Die ausgebildeten dreidimensionalen Objekte sind in vorteilhafter Weise ohne die sonst nötigen Klebeschritte direkt verwend- oder weiterverarbeitbar.

In einer weiteren Ausführungsform ist ein Vereinzeln vorgesehen. Das heißt, dass der Träger umfassend mehrere Halbleiterbauteile nach dem Ausbilden der dreidimensionale Objekte vereinzelt wird. Ein dreidimensional ausgebildetes Objekt ist zum Beispiel eine Bauteilseitenwand, zum Beispiel eine Gehäuseseitenwand eines Gehäuses für das Halbleiterbauteil.

Es werden somit insbesondere Bauteilseitenwände, zum Beispiel mittels einer weißen 3D-Druckmasse, und/oder Lichtleiter geformt. Werden die Bauteilseitenwände mittels des erfindungsgemäßen 3D-Druckverfahrens ausgebildet, so lassen sich in vorteilhafter Weise Formen herstellen, die in einem Spritzguss nicht herzustellen sind. Zum Beispiel weisen Gehäuseseitenwände Unterschnitte auf oder sind als Hohlkörper mit Öffnungen ausgebildet.

Dies ist insbesondere dann von Vorteil, wenn auf dem Träger Infrarotsende- und -empfangsdioden angeordnet sind, wo es auf eine gute Abschattung oder Abschirmung der Sendediode von der Empfangsdiode ankommt, das externe Reflexionssignal aber gut weitergeleitet werden soll. Das heißt, dass nach einer Ausführungsform eine Infrarotsende- und eine Infrarotempfangsdiode auf dem Träger angeordnet sind, die mit entsprechend ausgebildeten Gehäuseseitenwänden voneinander abgeschirmt sind.

Auch eine Verwendung eines dreidimensionalen Objekts als eine Shutterkante in Kraftfahrzeugfrontlichtern ist vorgesehen.

Nach einer Ausführungsform ist das ausgebildete dreidimensionale Objekt ein Lichtleiter. Solch ausgebildete Lichtleiter können somit in vorteilhafter Weise effizient ausgehend von dem Träger, der auch als ein Substrat bezeichnet werden kann, mit den LED-Chips quasi in Freiform hergestellt werden.

In einer weiteren Ausführungsform ist das dreidimensionale ausgebildete Objekt eine Freiformlinse. Mittels des erfindungsgemäßen 3D-Druckverfahrens können in vorteilhafter Weise Freiformlinsen direkt auf Bauteile oder mit LED-Chips bestückten Trägerplatten aufgedruckt werden. Dies weist insbesondere den Vorteil einer leichten Adaptierbarkeit und eines Variantenreichtums auf. Zum Beispiel ist vorgesehen, auf diese Weise ein Array aus LED-Halbleiterbauteilen jeweils mit einer individuellen Linsenform zu versehen, bei dem jede Linse eine individuell angepasste Abstrahlrichtung hat, so dass sich ein angepasstes Abstrahlprofil ergibt. Zum Beispiel ist vorgesehen, dass die mehreren Linsen derart ausgebildet sind, dass sie das Licht in einen gemeinsamen Brennpunkt im Fernfeld abbilden. Ein Vorteil gegenüber konventionell gefertigten Linsen besteht insbesondere darin, dass sich ohne eine aufwändige Herstellung von individuellen Moldformen (Vergussformen) schnell viele einzeln adaptierte Linsen herstellen lassen.

Nach einer Ausführungsform sind Vertiefungen (und/oder Löcher) und/oder Erhebungen auf dem Träger zur Verankerung vorgesehen, die von der polymerisierbaren Flüssigkeit entweder gefüllt oder umschlossen werden. Dies bewirkt in vorteilhafter Weise eine gute und stabile Verankerung der dreidimensional gedruckten Strukturen (dreidimensional ausgebildetes Objekt) auf dem Träger.

Es kann unter Umständen verfahrensbedingt schwierig sein, am Boden, also auf der Oberseite des Trägers, neben besonders hohen Chipstrukturen die dreidimensionalen Objekte anzuwachsen. Dies insbesondere wenn die Strukturen (zum Beispiel Chips mit Bonddrähten) höher sind als die Dicke des unwirksamen Bereichs. Daher ist nach einer Ausführungsform vorgesehen, dass zum Beispiel dünne Chips (Halbleiterchips mit einer maximalen Dicke von 100 µm) vorgesehen sind. Zum Beispiel wird anstelle einer elektrischen Kontaktierung mittels Bonddrähten eine lithographische Struktur zur elektrischen Kontaktierung verwendet. Zum Beispiel werden Flip-Chips ohne Oberseitenkontakte verwendet. Zum Beispiel sind die Chips in Vertiefungen gesetzt, die auf dem Träger, zum Beispiel durch eine strukturierte Zwischenschicht, gebildet sind.

Eine solch strukturierte Zwischenschicht, die an der Oberseite des Trägers neben den Halbleiterbauteilen angebracht oder ausgebildet ist, wirkt zum Beispiel auch als eine Haftvermittlerschicht für einen Lichtleiter.

Die Haftvermittlerschicht umfasst zum Beispiel eine Silikonbeschichtung.

Die strukturierte Zwischenschicht wird beispielsweise als hoch reflektiv gefüllter, ausgehärteter Verguss (zum Beispiel Titandioxidverguss) ausgeführt oder ausgebildet. Dies zum Beispiel im so genannten "Dam-and-Fill-Verfahren". Dieses Verfahren umfasst, dass ein Damm für das Vergussmaterial auf der Oberseite des Trägers ausgebildet wird, der dann beim Aufbringen des Vergussmaterials auf die Oberseite ein Herunterfließen des Vergussmaterials vom Träger verhindert.

Insbesondere für Lichtleiterlösungen in blauen oder weißen LEDs ist vorgesehen, die Halbleiterbauteile (LEDs) während und/oder vor dem Belichten zu betreiben, um um die LEDs herum eine besonders gute Anhaftung von 3D-Lichtleitern zu erreichen, da ein UV-Anteil des mittels der blauen LED emittierten Lichts die polymerisierbare Flüssigkeit aushärtet, so dass ein besserer Formschluss (Anhaftung) des Objekts an der LED erreicht werden kann.

Das heißt, dass gemäß diesem Konzept vorgesehen ist, dass das Halbleiterbauteil vor und/oder während des Belichtens betrieben wird, so dass das Halbleiterbauteil blaues oder weißes Licht emittiert, was dann zu einer Polymerisation der polymerisierbaren Flüssigkeit im unmittelbaren Umfeld des Halbleiterbauteils führt, was dann wiederum zu einer besseren Anhaftung oder zu einem besseren Formschluss führt.

In der Regel ist für eine LED eine hoch-reflektive Beschichtung der Oberfläche des Trägers oder ein gut reflektierendes Trägermaterial wichtig, um eine gute Lichteffizienz zu erzielen. Dies kann gegebenenfalls unter Umständen zu unerwünschten Reflexionen des Belichtungslichts, zum Beispiel des UV-Lichts, führen. Daher ist nach einer Ausführungsform vorgesehen, dass die Oberseite des Trägers eine Beschichtung aufweist, die UV-Licht zu mindestens 90 % absorbiert. Zum Beispiel ist nach einer Ausführungsform vorgesehen, dass das Trägermaterial des Trägers UV-Licht zu mindestens 90 % absorbiert. Dadurch kann also in vorteilhafter Weise unerwünschtes Streulicht und damit eine Verfälschung der gewünschten Form des dreidimensionalen Objekts vermieden werden.

Mittels des hier beschriebenen erfindungsgemäßen Verfahrens lassen sich in vorteilhafter Weise besonders einfach Lichtleiterlösungen für so genannte "Retrofits" erzeugen. Ein "Retrofit" bezeichnet eine Form, die in der Vergangenheit in Mode war oder in der Vergangenheit üblich war. Bei einem solchen Retrofit ist dann zum Beispiel vorgesehen, dass die LED in einem Sockel verschwindet, aber der Lichtleiter in den oberen Raum des zum Beispiel birnenförmigen Retrofits ragt, um den optischen Eindruck eines Glühfadens zu vermitteln. Auch hier bietet das dreidimensionale Druckverfahren, wie es vorstehend beschrieben wurde, den Vorteil einer freien Formgestaltung für solche Lichtleiter, die den Eindruck eines Glühfadens vermitteln sollen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

### BEZUGSZEICHENLISTE

- 101: erste optoelektronische Leuchtvorrichtung
- 103: Träger
- 105: Oberseite des Trägers
- 107: optoelektronisches Halbleiterbauteil
- 109: Unterseite des optoelektronischen Halbleiterbauteils
- 111: Oberseite des optoelektronischen Halbleiterbauteils
- 113: Bonddraht
- 115, 117: Gehäuseseitenwände
- 119: Abschnitt der Gehäuseseitenwand 115
- 121: Lücke einfügen
- 201: zweite optoelektronische Leuchtvorrichtung
- 203: Lichtleiter
- 205: geradliniger Abschnitt des Lichtleiters
- 207: Freiformabschnitt des Lichtleiters
- 209: konisch zulaufender Abschnitt des Lichtleiters
- 211: Lichtleiterverzweigung des Lichtleiters
- 301: dritte optoelektronische Leuchtvorrichtung
- 303: Linse
- 305: Lichtstrahl
- 307: Brennpunkt
- 401: vierte optoelektronische Leuchtvorrichtung
- 403: Gehäuse
- 405: elektrische Leitung
- 407: Freiformlinse
- 409: Oberseite des Gehäuses 403 einfügen
- 501: fünfte optoelektronische Leuchtvorrichtung
- 503: Verankerungsstruktur
- 505, 507: Bauteilabschnitte
- 509: Vertiefung
- 511: Spitzen
- 513: dreidimensionales Objekt
- 601: sechste optoelektronische Leuchtvorrichtung
- 603: dreidimensionales Objekt
- 701: siebente optoelektronische Leuchtvorrichtung
- 703: Damm
- 705: Vergussmaterial
- 707: dreidimensional ausgebildetes Objekt
- 801: achte optoelektronische Vorrichtung
- 803: optisch transparentes Element
- 805: Aufbaufläche
- 807: Aufbaubereich
- 809: unwirksamer Bereich
- 811: Zuführen eines Polymerisationsinhibitors
- 813: Belichtungslicht
- 815: dreidimensional ausgebildetes Objekt
- 817: Aushärtezone
- 819: Vorwärtsbewegung
- 901: Bereitstellen
- 903: Auffüllen
- 905: Belichten
- 907: fortlaufendes Aufrechterhalten
- 1001: Bereitstellen
- 1003: Einbringen
- 1005: Belichten
- 1007: Bilden eines unwirksamen Bereichs

## Patentansprüche

1. Verfahren zum Ausbilden eines oder mehrerer dreidimensionaler Objekte für eine einen Träger (103) mit einem optoelektronischen Halbleiterbauteil (107) umfassende optoelektronische Leuchtvorrichtung (101), umfassend die folgenden Schritte:
- Bereitstellen (1001) eines Trägers (103) einer optoelektronischen Leuchtvorrichtung (101), wobei auf dem Träger (103) ein optoelektronisches Halbleiterbauteil (107) angeordnet ist, wobei ein vom Träger (103) teilweise begrenzter Aufbaubereich (807) festgelegt ist, dem das optoelektronische Halbleiterbauteil (107) zugewandt ist,
- Einbringen (1003) einer polymerisierbaren Flüssigkeit in den Aufbaubereich (807),
- Belichten (1005) des Aufbaubereichs (807), um ein oder mehrere Festkörperpolymere aus der polymerisierbaren Flüssigkeit in einer vom Aufbaubereich umfassten Aushärtezone (817) auszubilden, um ein oder mehrere dreidimensionale Objekte (513) aus dem oder den mehreren Festkörperpolymeren in der Aushärtezone (817) auszubilden,
- wobei während des Belichtens (1005) des Aufbaubereichs (807) ein unwirksamer Bereich (809) gebildet (1007) wird, in welchem eine Polymerisation inhibiert wird, wobei die Aushärtezone zwischen dem Träger (103) und dem unwirksamen Bereich (809) angeordnet ist.

2. Verfahren nach Anspruch 1, umfassend ferner die folgenden Schritte:
- Bereitstellen eines optisch transparenten Elements (803) mit einer Aufbaufläche (805), wobei das optoelektronische Halbleiterbauteil (107) der Aufbaufläche (805) zugewandt ist, wobei der Aufbaubereich mittels des Trägers (103) und der Aufbaufläche (805) als der zwischen dem Träger (103) und der Aufbaufläche (805) liegende Bereich festgelegt wird,
- Auffüllen (903) des Aufbaubereichs (807) mit der polymerisierbaren Flüssigkeit,
- Belichten (905) des Aufbaubereichs (807) durch das optisch transparente Element (803) bei gleichzeitiger Vorwärtsbewegung (819) des Trägers (103) weg von der Aufbaufläche (805), um in der Aushärtezone (817) ein oder mehrere Festkörperpolymere aus der polymerisierbaren Flüssigkeit auszubilden, um ein oder mehrere dreidimensionale Objekte (513) in der Aushärtezone (817) aus dem oder den mehreren Festkörperpolymeren auszubilden, bei gleichzeitiger Ausführung des folgenden Schritts:
- fortlaufendes Aufrechterhalten (907) eines Kontakts zwischen dem unwirksamen Bereich (809) der polymerisierbaren Flüssigkeit und der Aufbaufläche (805).

3. Verfahren nach Anspruch 1 oder 2, wobei das oder die mehreren dreidimensionalen Objekte jeweils ein Element ausgewählt aus der folgende Gruppe von dreidimensionalen Objekten sind: Gehäusewand (115, 117) für ein Gehäuse für das Halbleiterbauteil (107), Lichtleiter (203) zum Leiten von mittels des Halbleiterbauteils (107) emittierten Lichts weg vom Halbleiterbauteil (107), Linse (303, 407) zum optischen Abbilden von mittels des Halbleiterbauteils (107) emittierten Lichts.

4. Verfahren nach Anspruch 3, wobei bei einer Gehäusewand (115, 117) diese derart ausgebildet wird, dass die Gehäusewand (115, 117)eine dem Träger (103) abgewandte Halbleiterbauteilfläche des Halbleiterbauteils (107) überragt, um die Halbleiterbauteilfläche zumindest teilweise gegen elektromagnetische Strahlung abzuschirmen.

5. Verfahren nach Anspruch 3 oder 4, wobei bei einem Lichtleiter (203) dieser auf einer lichtemittierenden Fläche des Halbleiterbauteils (107) ausgebildet wird.

6. Verfahren nach einem der Ansprüche 3 bis 5, wobei bei einer Linse (303, 407) diese auf einer lichtemittierenden Fläche des Halbleiterbauteils (107) ausgebildet wird.

7. Verfahren nach einem der vorherigen Ansprüche, wobei eine Verankerungsstruktur (503, 505; 507, 509, 511) zum Verankern des oder der mehreren Festkörperpolymere am Träger (103) vorgesehen ist.

8. Verfahren nach Anspruch 7, wobei die Verankerungsstruktur zumindest teilweise integral mit dem Träger (103) ausgebildet ist und/oder wobei die Verankerungsstruktur zumindest teilweise als ein körperlich vom Träger (103) separates und auf diesem angeordnetes Bauteil ausgebildet ist.

9. Verfahren nach einem der vorherigen Ansprüche, wobei eine Haftvermittlerschicht zum Anhaften des oder der mehreren Festkörperpolymere am Träger (103) vorgesehen ist.

10. Verfahren nach einem der vorherigen Ansprüche, wobei nach dem Einbringen der polymerisierbaren Flüssigkeit in den Aufbaubereich (807) und vor und/oder während des Belichtens mittels des Halbleiterbauteils (107) ultraviolettes Licht emittiert wird, um die polymerisierbare Flüssigkeit zu polymerisieren.

11. Verfahren nach einem der vorherigen Ansprüche, wobei der Träger (103) eine Beschichtung aufweist, die ausgebildet ist, eine Wellenlänge des Belichtungslichts zu mindestens 50 % zu absorbieren.

12. Optoelektronische Leuchtvorrichtung (101), umfassend:
- einen Träger (103), auf welchem ein optoelektronisches Halbleiterbauteil (107) angeordnet ist, und
- ein oder mehrere dreidimensionale Objekte, die jeweils mittels des Verfahrens nach einem der vorherigen Ansprüche ausgebildet sind.

## Claims

1. Method for forming one or more three-dimensional objects for an optoelectronic lighting device (101) comprising a carrier (103) with an optoelectronic semiconductor component (107), comprising the following steps:
- providing (1001) a carrier (103) of an optoelectronic lighting device (101), wherein an optoelectronic semiconductor component (107) is arranged on the carrier (103), wherein a construction region (807) that is partly delimited by the carrier (103) is defined, the optoelectronic semiconductor component (107) facing said construction region,
- introducing (1003) a polymerizable liquid into the construction region (807),
- exposing (1005) the construction region (807) in order to form one or more solid polymers from the polymerizable liquid in a curing zone (817) comprised by the construction region, in order to form one or more three-dimensional objects (513) from said one or more solid polymers in the curing zone (817),
- wherein an ineffective region (809) is formed (1007) during the process of exposing (1005) the construction region (807), polymerization being inhibited in said ineffective region, wherein the curing zone is arranged between the carrier (103) and the ineffective region (809).

2. Method according to Claim 1, furthermore comprising the following steps:
- providing an optically transparent element (803) comprising a construction surface (805), wherein the optoelectronic semiconductor component (107) faces the construction surface (805), wherein the construction region is defined by means of the carrier (103) and the construction surface (805) as the region lying between the carrier (103) and the construction surface (805),
- filling (903) the construction region (807) with the polymerizable liquid,
- exposing (905) the construction region (807) through the optically transparent element (803) with simultaneous forward movement (819) of the carrier (103) away from the construction surface (805) in order to form one or more solid polymers from the polymerizable liquid in the curing zone (817), in order to form one or more three-dimensional objects (513) from said one or more solid polymers in the curing zone (817), with the following step simultaneously being performed:
- continuously maintaining (907) a contact between the ineffective region (809) of the polymerizable liquid and the construction surface (805).

3. Method according to Claim 1 or 2, wherein said one or more three-dimensional objects are in each case an element selected from the following group of three-dimensional objects: housing wall (115, 117) for a housing for the semiconductor component (107), optical waveguide (203) for guiding light emitted by means of the semiconductor component (107) away from the semiconductor component (107), lens (303, 407) for optically imaging light emitted by means of the semiconductor component (107).

4. Method according to Claim 3, wherein, in the case of a housing wall (115, 117) the latter is formed in such a way that the housing wall (115, 117) projects beyond a semiconductor component surface of the semiconductor component (107) that faces away from the carrier (103), in order at least partly to shield the semiconductor component surface from electromagnetic radiation.

5. Method according to Claim 3 or 4, wherein, in the case of an optical waveguide (203), the latter is formed on a light emitting surface of the semiconductor component (107).

6. Method according to any one of Claims 3 to 5, wherein, in the case of a lens (303, 407), the latter is formed on a light emitting surface of the semiconductor component (107).

7. Method according to any one of the preceding claims, wherein provision is made of an anchoring structure (503, 505; 507, 509, 511) for anchoring said one or more solid polymers on the carrier (103).

8. Method according to Claim 7, wherein the anchoring structure is formed at least partly integrally with the carrier (103), and/or wherein the anchoring structure is formed at least partly as a component which is physically separate from the carrier (103) and is arranged thereon.

9. Method according to any one of the preceding claims, wherein provision is made of an adhesion promoter layer for enabling said one more solid polymers to adhere to the carrier (103).

10. Method according to any one of the preceding claims, wherein after the process of introducing the polymerizable liquid into the construction region (807) and before and/or during the process of exposing by means of the semiconductor component (107), ultraviolet light is emitted in order to polymerize the polymerizable liquid.

11. Method according to any one of the preceding claims, wherein the carrier (103) comprises a coating configured to absorb at least 50% of a wavelength of the exposure light.

12. Optoelectronic lighting device (101), comprising:
- a carrier (103), on which an optoelectronic semiconductor component (107) is arranged, and
- one or more three-dimensional objects formed in each case by means of the method according to any one of the preceding claims.

## Revendications

1. Procédé de formation d'un ou plusieurs objets tridimensionnels pour un dispositif d'éclairage (101) optoélectronique comprenant un élément porteur (103) pourvu d'un composant semiconducteur (107) optoélectronique, comprenant les étapes suivantes :
- fourniture (1001) d'un élément porteur (103) d'un dispositif d'éclairage (101) optoélectronique, un composant semiconducteur (107) optoélectronique étant disposé sur l'élément porteur (103), une zone de construction (807) partiellement délimitée par l'élément porteur (103), à laquelle fait face le composant semiconducteur (107) optoélectronique, étant définie,
- incorporation (1003) d'un liquide polymérisable dans la zone de construction (807),
- éclairage (1005) de la zone de construction (807) afin de former un ou plusieurs polymères à corps solide à partir du liquide polymérisable dans une zone de durcissement (817) comprise par la zone de construction, en vue de former un ou plusieurs objets tridimensionnels (513) à partir du ou des plusieurs polymères à corps solide dans la zone de durcissement (817),
- une zone inopérante (809) étant formée (1007) pendant l'éclairage (1005) de la zone de construction (807), dans laquelle une polymérisation est inhibée, la zone de durcissement étant disposée entre l'élément porteur (103) et la zone inopérante (809).

2. Procédé selon la revendication 1, comprenant en outre les étapes suivantes :
- fourniture d'un élément optiquement transparent (803) muni d'une surface de construction (805), le composant semiconducteur (107) optoélectronique faisant face à la surface de construction (805), la zone de construction étant définie au moyen de l'élément porteur (103) et de la surface de construction (805) en tant que zone qui se trouve entre l'élément porteur (103) et la surface de construction (805),
- remplissage (903) de la zone de construction (807) avec le liquide polymérisable,
- éclairage (905) de la zone de construction (807) à travers l'élément optiquement transparent (803) lors du mouvement d'avance (819) simultané de l'élément porteur (103) à l'écart de la surface de construction (805) afin de former, dans la zone de durcissement (817), un ou plusieurs polymères à corps solide à partir du liquide polymérisable, en vue de former un ou plusieurs objets tridimensionnels (513) dans la zone de durcissement (817) à partir du ou des plusieurs polymères à corps solide, tout en exécutant simultanément l'étape suivante :
- maintien continuel (907) d'un contact entre la zone inopérante (809) du liquide polymérisable et la surface de construction (805).

3. Procédé selon la revendication 1 ou 2, le ou les plusieurs objets tridimensionnels étant respectivement un élément choisi parmi le groupe d'objets tridimensionnels suivant : paroi de boîtier (115, 117) pour un boîtier pour le composant semiconducteur (107), fibre optique (203) destinée à conduire la lumière émise au moyen du composant semiconducteur (107) à l'écart du composant semiconducteur (107), lentille (303, 407) destinée à représenter optiquement la lumière émise au moyen du composant semiconducteur (107).

4. Procédé selon la revendication 3, lorsqu'il s'agit d'une paroi de boîtier (115, 117), celle-ci étant configurée de telle sorte que la paroi de boîtier (115, 117) fait saillie d'une surface de composant semiconducteur du composant semiconducteur (107) qui est à l'opposé de l'élément porteur (103) afin de réaliser un blindage au moins partiel de la surface de composant semiconducteur contre le rayonnement électromagnétique.

5. Procédé selon la revendication 3 ou 4, lorsqu'il s'agit d'une fibre optique (203), celle-ci étant formée sur une surface émettrice de lumière du composant semiconducteur (107).

6. Procédé selon l'une des revendications 3 à 5, lorsqu'il s'agit d'une lentille (303, 407), celle-ci étant formée sur une surface émettrice de lumière du composant semiconducteur (107).

7. Procédé selon l'une des revendications précédentes, une structure d'ancrage (503, 505 ; 507, 509, 511) destinée à ancrer le ou les plusieurs polymères à corps solide à l'élément porteur (103) étant présente.

8. Procédé selon la revendication 7, la structure d'ancrage étant au moins partiellement formée d'un seul tenant avec l'élément porteur (103) et/ou la structure d'ancrage étant au moins partiellement réalisée sous la forme d'un élément structural physiquement séparé de l'élément porteur (103) et disposé sur celui-ci.

9. Procédé selon l'une des revendications précédentes, une couche d'agent adhésif servant à faire adhérer le ou les plusieurs polymères à corps solide à l'élément porteur (103) étant présente.

10. Procédé selon l'une des revendications précédentes, de la lumière ultraviolette étant émise après l'incorporation du liquide polymérisable dans la zone de construction (807) et avant et/ou pendant l'éclairage au moyen du composant semiconducteur (107) afin de polymériser le liquide polymérisable.

11. Procédé selon l'une des revendications précédentes, l'élément porteur (103) possédant un revêtement qui est configuré pour absorber à au moins 50 % une longueur d'onde de la lumière d'éclairage.

12. Dispositif d'éclairage optoélectronique (101) comprenant :
- un élément porteur (103) sur lequel est disposé un composant semiconducteur (107) optoélectronique, et
- un ou plusieurs objets tridimensionnels qui sont respectivement formés au moyen du procédé selon l'une des revendications précédentes.
